# EUROPÄISCHE PATENTSCHRIFT

(11) **EP 1 540 745 B1**
(45) Veröffentlichungstag und Bekanntmachung des Hinweises auf die Patenterteilung: **29.10.2014**
(21) Anmeldenummer: 03747830.2
(22) Anmeldetag: 05.09.2003
(51) Int. Cl.: H01L 33/00, H01L 31/0203, H01L 33/48, H01L 33/62

(54) **VERFAHREN ZUR HERSTELLUNG EINES LEADFRAME-BASIERTEN GEHÄUSES**
PRODUCTION METHOD FOR LEADFRAME-BASED COMPONENT HOUSING
PROCEDE DE PRODUCTION D'UN BOITIER DE COMPOSANT A CADRE DE MONTAGE

(30) Priorität: 17.09.2002 DE 10243247
(43) Veröffentlichungstag der Anmeldung: 15.06.2005
(73) Patentinhaber: OSRAM Opto Semiconductors GmbH, 93055 Regensburg (DE)
(72) Erfinder: SORG, Jörg, Erich, 93053 Regensburg (DE)
(74) Vertreter: Epping - Hermann - Fischer
(86) Internationale Anmeldenummer: PCT/DE2003/002953
(87) Internationale Veröffentlichungsnummer: WO 2004/027882

(56) Entgegenhaltungen:
- EP-A- 0 723 293
- EP-A- 0 854 523
- WO-A-03/019677
- US-A- 4 791 472
- US-A- 4 803 544
- PATENT ABSTRACTS OF JAPAN vol. 2000, no. 03, 30. März 2000 (2000-03-30) -& JP 11 340403 A (SONY CORP), 10. Dezember 1999 (1999-12-10)
- PATENT ABSTRACTS OF JAPAN vol. 007, no. 264 (E-212), 24. November 1983 (1983-11-24) & JP 58 147141 A (NIPPON DENKI KK), 1. September 1983 (1983-09-01)

## Beschreibung

Die Erfindung betrifft ein Verfahren zur Herstellung eines Leadframe-basierten Bauelement-Gehäuses.

Die Erfindung betrifft insbesondere zur Oberflächenmontage auf einer Leiterplatte geeignete Leuchtdiodenbauelemente, bei denen in einem im Spritzverfahren gefertigten Gehäuse-Grundkörper mit teilweise eingebetteten elektrischen Anschlußstreifen eine vorzugsweise als Reflektor ausgebildete Ausnehmung mit einem zur Vorderseite des Bauelement-Gehäuses hin gerichteten Strahlungsfenster vorgesehen ist. Die Ausnehmung, in der sich ein elektromagnetische Strahlung emittierender Chip befindet, ist beispielsweise mit einer Verkapselungsmasse gefüllt, die für vom Chip ausgesandte elektromagnetische Strahlung durchlässig ist.

Derartige Bauelement-Gehäuse eignen sich auch für die Verwendung bei strahlungsdetektierenden Chips - das Strahlungsfenster muß dann für eine vom Chip zu empfangende elektromagnetische Strahlung durchlässig sein.

Die Erfindung eignet sich insbesondere zur Anwendung bei strahlungsemittierenden Bauelementen, bei denen die Chips in vorgehäuste Leadframes, sogenannte "premolded Leadframes" eingebaut werden. Dies bedeutet, daß die Leadframes jeweils vor der Montage des Chips mit einem Gehäuse-Grundkörper umspritzt sind.

Bei der Herstellung eines solchen Bauelement-Gehäuses werden zunächst die Anschlußstreifen in ein Leadframe-Band teilweise gestanzt. Danach wird das Leadframe-Band in eine zweiteilige Spritzform eingelegt, welche um das Leadframe eine Kavität zur Ausbildung des Gehäuse-Grundkörpers bildet.

Nachfolgend wird mit Hilfe einer Spritzdüse beispielsweise über den an die Rückseite des Leadframes grenzenden Teil der Spritzform, das heißt in den an die Rückseite des Leadframes grenzenden Teil der Kavität eine Spritzmasse, z. B. ein weißer Kunststoff, eingefüllt, und die gesamte Kavität der Spritzform gefüllt.

Nach dem zumindest teilweisen Aushärten der Spritzmasse wird die Spritzform geöffnet. Bei der Entnahme des Leadframes aus der Form wird die in der Spritzdüse befindliche Spritzmasse von der in der Kavität befindlichen Spritzmasse abgerissen. Ferner wird der Chip in der dafür vorgesehenen Ausnehmung vorzugsweise auf einem der Anschlußstreifen angeordnet, elektrisch leitend mit den Anschlußstreifen verbunden und mit der Verkapselungsmasse versehen. Nachfolgend können die durch das Leadframe-Band verbundenen Bauelemente voneinander getrennt und somit aus diesem Verbund vereinzelt werden.

Ein strahlungsemittierendes Bauelement der genannten Art ist beispielsweise in der EP 0 400 176 A1 beschrieben. Das Bauelement weist einen Gehäuse-Grundkörper mit einer Auflagefläche auf, in den ein Leadframe (Leiterrahmen) teilweise eingebettet ist. Teile des Leadframes sind als Anschlußstreifen ausgebildet, die aus dem Gehäuse-Grundkörper herausragen und im weiteren Verlauf so gebogen sind, daß ihre Anschlußflächen mit der Auflagefläche, welche die Montageebene des Bauelements festlegt, in einer Ebene liegen.

Die Gesamthöhe der auf diese Weise hergestellten Bauelemente läßt sich, wenn überhaupt, dann nur mit hohem technischen Aufwand auf weniger als etwa 1 mm absenken. Die Mindesthöhe des Vorderteils des Gehäuse-Grundkörpers beträgt dabei etwa 0,5 mm, die der Rückwand des Gehäuse-Grundkörpers etwa 0,3 mm und die Dicke der Anschlußstreifen ca. 0,1 mm.

Der Grund dafür ist, daß die Schichtdicke der in der Kavität befindlichen Spritzmasse zwischen Leadframe und Abriss-Stelle an der Spritzdüse hinreichend groß sein muß, um eine Delamination zwischen Leadframe-Rückseite und Spritzmasse weitestgehend zu verhindern. Eine solche Delamination würde die Gefahr einer Schädigung des Bauelements während der weiteren Prozessierung oder später im Betrieb drastisch erhöhen. Nach derzeitigem Kenntnisstand muß die oben genannte Schichtdicke der Spritzmasse so groß sein, dass die beim Abreißen der Spritzdüse auftretenden mechanischen Zugkräfte in der Spritzmasse so weit abgebaut werden, dass die an der Grenze zum Leadframe angreifenden Kräfte nicht ausreichen, um die Spritzmasse vom Leadframe abzureißen.

Um beispielsweise eine geringe Bauhöhe auf Leiterplatten und/oder ein vollständiges Versenken in insbesondere runden Leiterbahndurchbrüchen (Bohrungen) zu ermöglichen, ist aber die Höhe der Bauelemente so gering wie möglich zu halten und es besteht dringender Bedarf, die Bauhöhe deutlicher unter die oben genannte kritische Höhe von etwa 1 mm abzusenken. Bei einigen Anwendungen, insbesondere in den Endgeräten der mobilen Kommunikation, sollen die strahlungsemittierenden Bauelemente eine deutlich geringere Höhe aufweisen.

Die Möglichkeit, die Bauelement-Höhe durch die Verringerung der Höhe des Gehäuse-Grundkörpers von der Seite des Chips her zu reduzieren, ist wegen einer endlichen Höhe des strahlungsemittierenden Chips stark begrenzt. Die Möglichkeit, das angegebene Ziel durch eine einfache Verringerung der Dicke des Gehäuse-Grundkörpers an der Rückseite des Leadframes zu erreichen, ist auch stark eingeschränkt, da, wie oben bereits dargelegt, bei einer zu dünnen Schicht der Spritzmasse, welche die Rückseite des Gehäuses realisiert, diese im Spritzverfahren zur Herstellung des Gehäuses leicht mit der zu entfernenden Spritzdüse mitgerissen wird, wobei die Hermetizität des Bauelements zerstört und damit die Funktionsweise des Bauelements gestört werden kann.

Die Druckschrift JP 11-340403 A zeigt den Oberbegriff von Anspruch 1.

Ein Licht emittierendes Halbleiterbauteil sowie eine Herstellungsmethode hierfür sind in der Druckschrift EP 0 854 523 A2 offenbart.

In der Druckschrift EP 0 723 293 A1 sind ein Halbleiterbauteil mit einer Wärmesenke und eine Herstellungsmethode für die Wärmesenke angegeben.

Es ist Aufgabe der vorliegenden Erfindung, ein Verfahren zur Herstellung eines Leadframebasierten Gehäuses anzugeben.

Diese Aufgabe wird durch ein Verfahren mit den Merkmalen des Patentanspruches 1 gelöst. Vorteilhafte Weiterbildungen der Erfindung sind Gegenstand der abhängigen Ansprüche.

Ein Leadframe-basiertes Gehäuse gemäß dem Verfahren der Erfindung für ein oberflächenmontierbares elektronisches Bauelement weist folgende Bestandteile auf:
- ein eine Vorderseite und eine Rückseite aufweisendes Leadframe, das zumindest zwei elektrische Anschlußstreifen umfaßt,
- einen spritzgegossenen oder spritzgepreßten Gehäuse-Grundkörper aus einer elektrisch isolierenden Spritzmasse,
- ein an der Vorderseite des Leadframes angeordnetes Vorderteil und eine an der Rückseite des Leadframes angeordnete Rückwand des Gehäuse-Grundkörpers,
- zumindest ein Anspritz-Fenster im Leadframe zum Ansetzen oder Einführen einer Spritzdüse, durch welches hindurch die Spritzmasse von einer Rückseite des Leadframes her an das Leadframe gespritzt ist.

Das Einspritzen der Spritzmasse erfolgt somit von der Rückseite des Leadframes her durch das Anspritz-Fenster hindurch in den Teil der Kavität der Spritzform hinein, der den Vorderteil des Gehäuse-Grundkörpers an der Vorderseite des Leadframes erzeugt. Die Spritzdüse wird beim Anspritzen durch den Teil der Kavität hindurch, der den Rückwandteil des Gehäuse-Grundkörpers an der Rückseite des Leadframes erzeugt, zum Anspritz-Fenster des Leadframes geführt. Auf diese Weise wird erreicht, dass an die Spritzdüse und damit an den Abrißbereich der Spritzmasse am kavitätsseitigen Ende der Spritzdüse ein vergleichsweise großes Spritzmassenvolumen mit vergleichsweise großem Querschnitt angrenzt. Die Gefahr einer Delamination ist bei dieser Art von Gehäuse reduziert.

Das Anspritz-Fenster ist vorzugsweise in einem der elektrischen Anschlußstreifen angeordnet. Die Rückwand, das heißt die Kunststoffwand zwischen der Rückseite des Leadframes und der Rückseite des Gehäuse-Grundkörpers wird mit Vorteil mit einer Dicke von 0,3 mm oder weniger, vorzugsweise von 0,25 mm oder weniger, besonders bevorzugt 0,2 mm oder weniger erzeugt, wobei es sich versteht, dass die Dicke in jedem. Fall größer als 0 mm ist.

Besonders bevorzugt eignet sich die Erfindung zur Anwendung bei Bauelementen, bei denen im Vorderteil des Gehäuse-Grundkörpers zumindest eine Ausnehmung zur Aufnahme eines Chips, insbesondere eines strahlungsemittierenden oder strahlungsdetektierenden Halbleiterchips, z. B. einer Lichtemissionsdiode, vorgesehen ist.

Das Anspritz-Fenster ist hierbei im Bereich einer die Ausnehmung begrenzenden Wand des Vorderteils angeordnet. Dort ist vorteilhafterweise bereits bauformbedingt ein großes Spritzmasse-Volumen vorhanden.

In der Ausnehmung ist eine Chip-Montagefläche vorgesehen, die sich vorzugsweise auf einem der beiden Anschlußstreifen befindet, aber auch auf dem Gehäusegrundkörper angeordnet sein kann. Eine solche Chip-Montagefläche kann aber auch erst später zum Beispiel in Form eines nachträglich in die Ausnehmung einzusetzenden Trägerplättchens bereitgestellt werden. Denkbar ist weiterhin, daß in den Gehäuse-Grundkörper ein thermischer Anschlußsockel eingesetzt ist, der vorzugsweise vom Boden der Ausnehmung durch den Gehäuse-Grundkörper zu dessen Rückseite reicht.

Der Chip kann beispielsweise je nach Anordnung seiner Kontaktflächen
- mittels zweier Bonddrähte mit den elektrischen Anschlußstreifen elektrisch verbunden werden,
- mit einer Kontaktfläche auf einen der beiden Anschlußstreifen mittels eines elektrischen Verbindungsmittels befestigt und mittels eines Bonddrahtes mit dem zweiten Anschlußstreifen verbunden werden, oder
- in Flip-Chip-Montage mit seinen Kontaktflächen unmittelbar auf die Streifen aufgesetzt werden.

Selbstverständlich sind auch noch andere elektrische Anschlußvarianten möglich, die der Fachmann je nach Design seines Chips auswählen wird.

Bei strahlungsemittierenden Bauelementen, bei denen die vorliegende Erfindung besonders bevorzugt Anwendung findet, weist die Ausnehmung ein Strahlungsaustrittsfenster auf.

Die Innenflächen der Ausnehmung sind hierbei vorzugsweise als Strahlungsreflektor ausgebildet.

Die Spritzmasse weist vorzugsweise einen Kunststoff, insbesondere einen temperaturbeständigen, mit weißem Füllstoff gefüllten Kunststoff auf. Der Kunststoff ist vorzugsweise Thermoplastmaterial, und der Füllstoff ist vorzugsweise Titanoxid und/oder Bariumsulfat.

Geeignete Materialien für ein Umhüllen eines Chips in der Ausnehmung, zum Beispiel Reaktionsharze wie Epoxidharze, Acrylharze, Silikonharze und Polyurethanharze, sind dem Fachmann bekannt und werden von daher vorliegend nicht näher erläutert.

Analoges gilt für die Spritzmasse des Gehäuse-Grundkörpers. Ebenso lassen sich vorliegend vorteilhafterweise bekannte und herkömmlich eingesetzte Methoden zur Montage und zur elektrischen Kontaktierung von Chips anwenden.

Ein nicht erfindungsgemäßes Verfahren umfaßt insbesondere folgende Schritte:
- Vorstrukturieren der Anschlußstreifen und des Anspritz-Fensters in einem Leadframe-Band z. B. durch Stanzen, Ätzen oder Laserschneiden, wobei im Leadframe-Band vorzugsweise mehrere nebeneinander (periodisch) angeordnete Bauelementbereiche, die später jeweils mit einem Gehäuse-Grundkörper versehen werden, ausgebildet werden,
- Anlegen einer Spritzgußform, die zwei- oder mehrteilig sein kann, an das Leadframe,
- Einspritzen der Spritzmasse in die Spritzform durch das Anspritz-Fenster, wobei die Spritzdüse des Spritzautomaten an das Anspritz-Fenster angelegt oder in das Anspritz-Fenster eingeführt wird
- Zumindest teilweises Aushärten der Spritzmasse, und
- Öffnen der Spritzform und Entfernen der Spritzdüse.

Das Anspritz-Fenster befindet sich bei einem Gehäuse-Grundkörper mit Ausnehmung für den Chip besonders bevorzugt unterhalb einer die Ausnehmung zumindest teilweise umschließenden massiven Wand des Gehäuse-Grundkörpers.

Der besondere Vorteil des erfindungsgemäßen Herstellungsverfahrens besteht darin, daß die Gesamthöhe eines damit herzustellenden Bauelement-Gehäuses durch die besonders dünn ausgebildete Rückwand des Bauelement-Gehäuses, insbesondere gegenüber den bisher bekannten strahlungsemittierenden Bauelementen, die mittels vorgehäusten Leadframes hergestellt werden, wesentlich reduziert werden kann.

Vorliegend bezieht sich der Begriff "Leadframe" insbesondere auf metallische Leiterrahmen, wie sie herkömmlich in der Halbleiter-Optoelektronik beispielsweise für Leuchtdiodengehäuse zum Einsatz kommen. Unter den Begriff "Leadframe" fallen vorliegend aber auch alle anderen für die erfindungsgemäße Gehäusetechnologie geeigneten Leiterrahmen, die nicht zwangsweise vollständig metallisch sein müssen und beispielsweise eine Kombination aus elektrisch isolierendem Material und auf diesen aufgebrachten elektrischen Leiterbahnen umfassen können. Dabei ist unter Leadframe nicht zwangsläufig ein durchgehendes Band zu verstehen, daß sich für eine "reel to reel" Technik eignet. Vielmehr kann das Leadframe z.B. auch in Form von Streifen oder Arrays vorliegen.

Weitere Merkmale, Vorteile und Weiterbildungen der Erfindung ergeben sich aus den nachfolgend in Verbindung mit den Figuren 1 bis 4 erläuterten Ausführungsbeispielen.

Es zeigen:
Figur 1 schematische perspektivische Ansicht von einem in Premold-Technik hergestellten strahlungsemittierenden Bauelement nach dem Stand der Technik,
Figur 2a eine schematische Aufsicht auf ein Leadframe-Band,
Figur 2b eine vergrößerte schematische Aufsicht auf zwei zusammengehörige Anschlußstreifen des Leadframes von Figur 2a,
Figur 2c eine schematische Aufsicht auf ein Leadframe-Band gemäß Figur 2a mit im Spritzverfahren ausgebildeten Gehäuse-Grundkörpern,
Figur 3a eine schematische Darstellung der Draufsicht eines weiteren Ausführungsbeispiels der Anschlußstreifen eines Bauelements,
Figur 3b eine schematische Darstellung der perspektivischen Unteransicht eines Gehäuse-Grundkörpers mit einem Leadframe gemäß Figur 3a,
Figur 3c eine schematische Darstellung der perspektivischen Ansicht von oben eines Gehäuse-Grundkörpers gemäß der Figur 3b,
Figuren 4a und 4b schematische Darstellungen jeweils eines Querschnitts durch einen Gehäuse-Grundkörper eines Bauelements nach Stand der Technik (4a) und eines anderen Bauelements (4b) während des Spritzens des Gehäuse-Grundkörpers,
Figuren 5a und 5b schematische Darstellungen eines Querschnitts durch jeweils einen Gehäuse-Grundkörper eines Bauelements nach Stand der Technik (5a) und einer weiteren Ausführungsform eines anderen Bauelements (5b) während des Spritzens des Gehäuse-Grundkörpers.

Gleiche oder gleichwirkende Elemente sind in den Figuren mit denselben Bezugszeichen versehen.

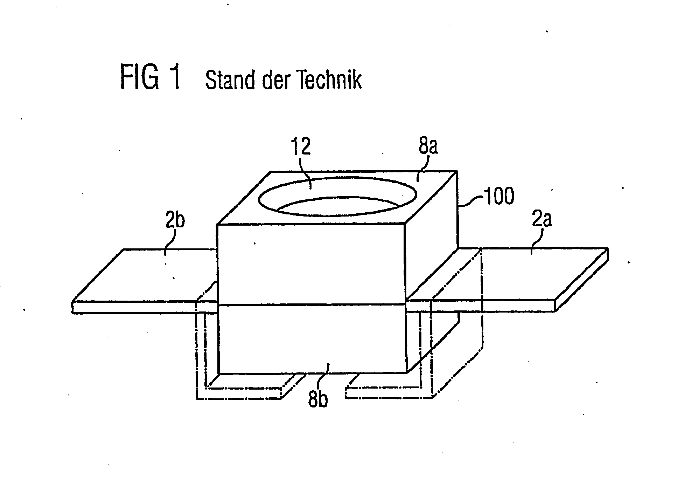

Die Figur 1 zeigt eine perspektivische Darstellung eines oberflächenmontierbaren Bauelements mit einem Gehäuse nach dem Stand der Technik.

Der in Figur 1 gezeigte, im Umriß rechteckige Gehäuse-Grundkörper 100, weist ein Vorderteil 8a und eine Rückwand 8b auf, wobei im Vorderteil 8a eine Reflektor-Ausnehmung mit einem Strahlungsaustrittsfenster 12 vorgesehen ist. Ein erster Anschlußstreifen 2a und ein zweiter Anschlußstreifen 2b sind im Gehäuse-Grundkörper teilweise eingebettet und an einen hier nicht dargestellten (im Inneren des Gehäuse-Grundkörpers verborgenen) strahlungsemittierenden Chip angeschlossen. Die hinausragenden Teile der Anschlußstreifen (Außenkontakte) dienen zum Kontaktieren des Bauelements, z. B. an eine externe Leiterplatte. Es ist möglich, daß die Außenkontakte senkrecht zur entsprechenden Seitenwand des Gehäuses verlaufen oder, wie mit einer gestrichelten Linie in Figur 1 angedeutet, um den Gehäuse-Grundkörper gebogen sind.

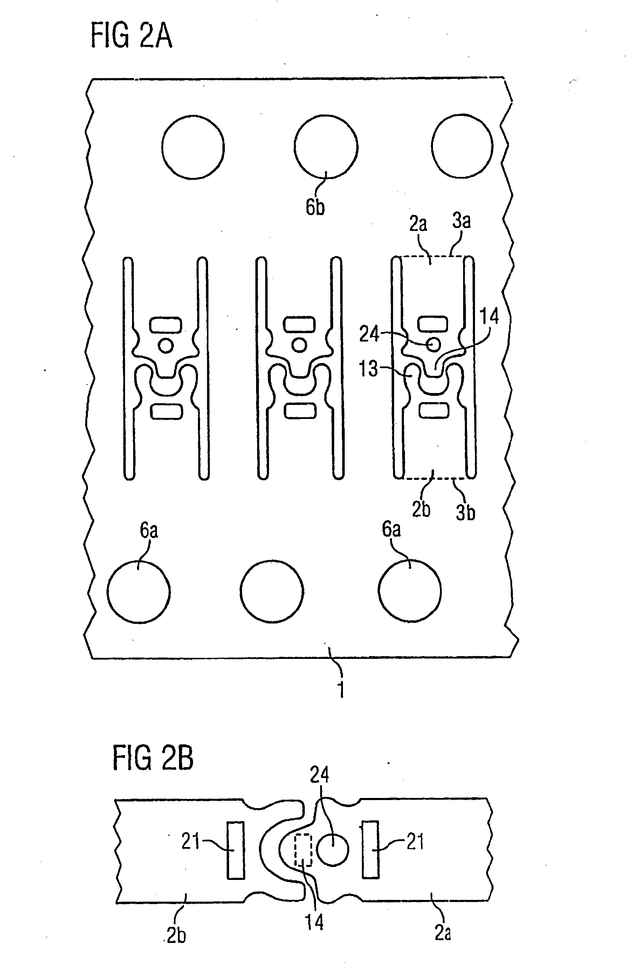

Das Leadframe-Band 1 gemäß dem Ausführungsbeispiel von Figuren 2a und 2b ist z. B. durch Stanzen vorstrukturiert und weist insbesondere eine Mehrzahl von ersten Anschlußstreifen 2a und eine Mehrzahl von zweiten Anschlußstreifen 2b auf, welche in einem späteren Verfahrensschritt vom Leadframe-Band entlang der Linien 3a bzw. 3b abgetrennt werden.

Die Anschlußstreifen 2a bzw. 2b sind als Kathoden- bzw. Anodenanschlüsse der zu fertigenden Bauelemente vorgesehen. Es können auf dem Leadframe-Band außerdem weitere Strukturen (z. B. Wärme ableitende Streifen) ausgebildet sein. Auf dem Anschlußstreifen 2a ist in diesem Ausführungsbeispiel eine Chip-Montagefläche 14 für einen Chip bzw. auf dem Anschlußstreifen 2b eine Drahtanschlußfläche 13 für einen Bonddraht vorgesehen. Auf dem ersten Anschlußstreifen 2a ist ein Anspritz-Fenster 24 vorgesehen, in das beim Ausbilden eines Gehäuse-Grundkörpers im Spritzverfahren eine Spritzdüse einführbar ist. Alternativ kann das Anspritz-Fenster in dem zweiten Anschlußstreifen 2b vorgesehen sein. Es ist zweckmäßig, daß die Anspritz-Fenster jeweils unterhalb einer später auszubildenden Seitenwand der Gehäuse-Grundkörper vorgesehen sind.

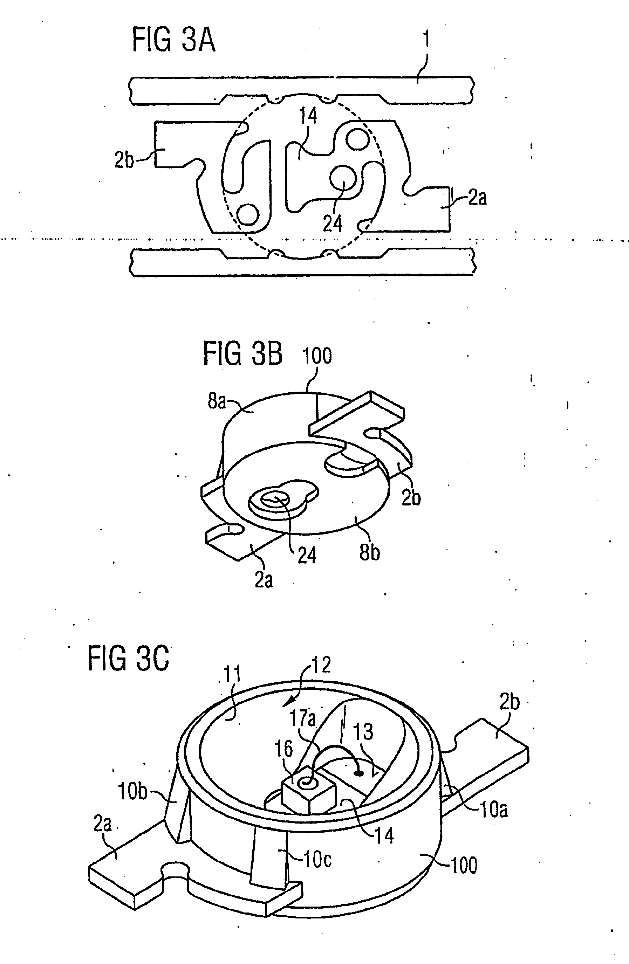

Die Chip-Montagefläche 14 bzw. die Drahtanschlußfläche 13 des Leadframe-Bands ragen (im fertigen Gehäuse-Grundkörper) in eine vorgesehene Reflektor-Ausnehmung hinein oder grenzen mit einer Oberfläche zumindest an den Innenraum der Ausnehmung an und bilden dann zumindest einen Teil der Bodenfläche der Ausnehmung. Hinsichtlich einer weiteren Verkleinerung des Gehäuse-Grundkörpers kann in der Reflektor-Ausnehmung zusätzlich eine gesonderte Aussparung gebildet sein, die zum Drahtanschlußbereich führt. Diese Aspekte sind in der Figur 3c zu erkennen.

In dem Leadframe-Band 1 sind ferner kreisförmige Durchbrüche 6a und 6b gebildet, durch welche das Leadframe-Band geführt und transportiert werden kann.

Die Anschlußstreifen 2a und 2b weisen darüber hinaus vorzugsweise rechteckig ausgebildete Durchbrüche 21 auf, welche zur Entlastung des Bauelement-Gehäuses beim Biegen der Anschlußstreifen (siehe Figur 1) bzw. zur Verankerung der Anschlußstreifen im Bauelement-Gehäuse geeignet sind.

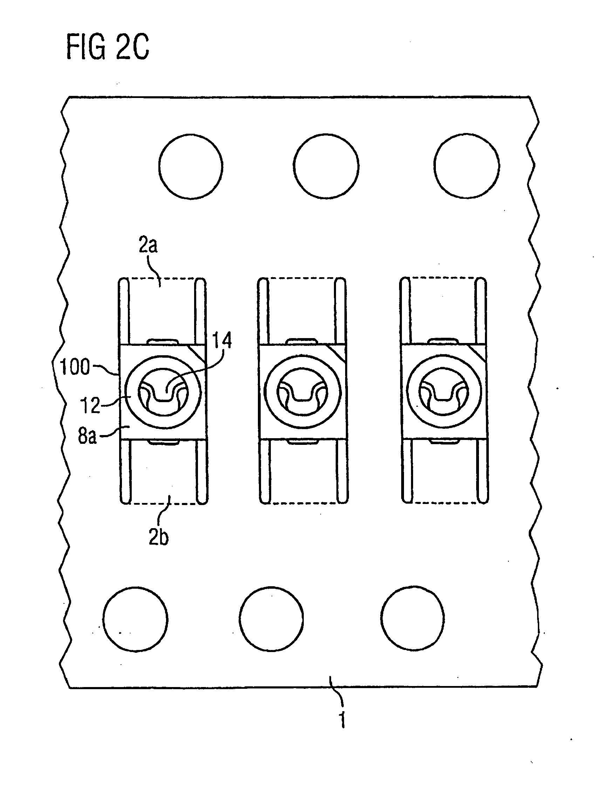

Figur 2c zeigt das Leadframe-Band 1 mit mittels eines Spritzverfahrens hergestellten Gehäuse-Grundkörpern 100 mit jeweils einer Chip-Montagefläche 14 und jeweils einer zu dieser Chip-Montagefläche führenden Ausnehmung.

Das in Figur 3a gezeigte Ausführungsbeispiel für ein Leadframe eines Gehäuses bzw. Bauelements mit einem im Wesentlichen kreisförmigen Umriß weist sichelartig ausgebildete Anschlußstreifen auf, was einerseits zur besseren Verankerung der Anschlußstreifen im Gehäuse-Grundkörper und andererseits zu einer federnden Zugentlastung bei Verbiegung der Anschlußstreifen dient. Auch dieses Leadframe weist ein neben einer Chip-Montagefläche 14 angeordnetes Anspritz-Fenster 24 auf, in oder an das zum Herstellen des Gehäuse-Grundkörpers eine Spritzdüse von der Rückseite des Leadframes her einführbar oder heranführbar ist.

Figur 3b zeigt einen Gehäuse-Grundkörper 100 mit im Wesentlichen kreisförmigem Umriß in perspektivischer Ansicht von unten. Zu erkennen ist hierbei das Anspritz-Fenster 24, durch das hindurch der Gehäuse-Grundkörper 100 in die Kavität einer entsprechenden Spritzform in den an die Vorderseite des Leadframes grenzenden Teil der Kavität eingespritzt wird. Das Vorderteil des Gehäuse-Grundkörpers 100 ist im Übrigen beispielsweise wie in Figur 3c gezeigt ausgestaltet. Diese Art von Gehäuse eignen sich besonders für die Herstellung von oberflächenmontierbaren strahlungsemittierenden und/oder strahlungsdetektierenden Bauelementen mit Leuchtdioden- und/oder Photodiodenchips, die in kreisrunden Durchbrüchen von Leiterplatten oder dergleichen zumindest teilweise versenkbar sind.

Das in Figur 3b gezeigte Bauelement ist in Figur 3c in perspektivischer Aufsicht dargestellt. Ein strahlungsemittierender Chip 16, beispielsweise ein Leuchtdiodenchip, ist in einer Reflektoröffnung, beispielsweise auf dem Anschlußstreifen 2a befestigt. Als Verbindungsmittel ist beispielsweise ein metallisches Lot oder ein Leitkleber verwendet. Ein zweiter Kontakt des Leuchtdiodenchips ist mit dem Anschlußstreifen 2b beispielsweise mittels eines Bonddrahtes 17a elektrisch verbunden. Die Seitenwand 11 einer Ausnehmung, welche die Bodenfläche der Ausnehmung mit der äußeren Fläche des Gehäuse-Grundkörpers 100 verbindet, ist derart ausgeführt, daß sie als Reflektorfläche für eine von dem Chip 16 abgestrahlte elektromagnetische Strahlung wirkt. Sie kann je nach gewünschtem Abstrahlverhalten eben, konkav oder anderweitig zweckmäßig geformt sein. Die in Figur 3c ersichtlichen Vorsprünge 10a, 10b und 10c des Gehäuse-Grundkörpers dienen zur Führung der außerhalb des Gehäuse-Grundkörpers liegenden Anschlußstreifen. Außerdem können sie auch als Einführschrägen zum Einführen des Gehäuses in Platinendurchbrüche dienen.

Auf der von dem Anschlußstreifen abgewandten Vorderseite weist der Chip 16 eine Kontaktfläche auf, von der aus eine elektrische Anschlußleitung 17 (z. B. eine Drahtverbindung) zu dem Drahtanschlußteil 13 geführt ist.

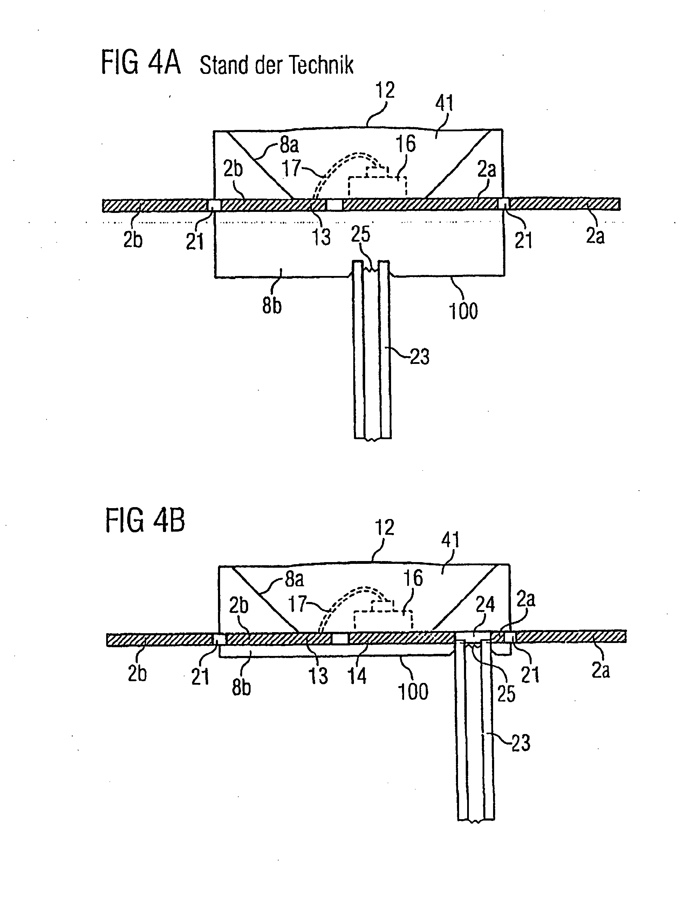

Der besondere Vorteil der Erfindung wird aus der in den Figuren 4a und 4b gezeigten Gegenüberstellung des Standes der Technik und dem durch die Erfindung erreichbaren Gehäuse ohne Weiteres ersichtlich.

Das Vorderteil 8a des Gehäuse-Grundkörpers 100, der beispielsweise für den späteren Einbau eines Leuchtdiodenchips vorgesehen ist, weist in beiden Fällen eine Reflektor-Ausnehmung in Form einer kegelstumpfartigen, sich in Richtung der Hauptabstrahlungsrichtung erweiternden Öffnung mit einem Strahlungsaustrittfenster 12 auf. Die Reflektor-Ausnehmung ist mit einer transparenten Verkapselungsmasse 41 gefüllt.

Ein in einem späteren Verfahrensschritt einzusetzender Chip 16 und eine elektrische Anschlußleitung 17 sind mit gestrichelten Linien schematisch dargestellt.

Die schrägstehende Seitenfläche 11 der Ausnehmung dient vorzugsweise als Reflektor.

Zum Ausbilden des Gehäuse-Grundkörpers 100 wird eine zwei-oder mehrteilige Spritzgußform mit einer Kavität für die Gehäuse-Grundkörper 100 verwendet, in welche das Leadframe während des Spritzverfahrens eingelegt ist. Die Kavität der Spritzform wird mittels einer Spritzdüse 23 mit einer Spritzmasse für den Gehäuse-Grundkörper gefüllt.

Der Unterschied zwischen dem Stand der Technik und der erfindungsgemäßen Führung der Spritzdüse findet sich in der Position der Spritzdüse 23. Nach dem Stand der Technik wird die Spritzmasse in das an die Rückseite des Leadframes grenzende Volumen eingespritzt. Nach dem Aushärten der Spritzmasse wird die Spritzdüse von der Spritzform abgetrennt. Dabei entsteht eine Abrißstelle 25. Beim Abtrennen der Spritzdüse ist der Bereich in der Nähe der Abrißstelle einer starken mechanischen Belastung ausgesetzt, die zur Delamination des Materials der (ausgehärteten) Spritzmasse an der Grenzfläche zwischen der Rückwand 8b des Gehäuse-Grundkörpers und den Anschlußstreifen 2a bzw. 2b führen kann. Daher kann bei einer geringen Höhe der Rückwand 8b diese leicht beschädigt werden. Um dies weitestgehend zu vermeiden, ist eine vergleichsweise große Dicke der Rückwand 8b des Gehäuse-Grundkörpers erforderlich.

Bei einem Verfahren gemäß der Erfindung ist die Spritzdüse 23 dagegen nicht im mittleren Bereich einer zum Ausbilden der Rückwand 8b des Gehäuse-Grundkörpers geeigneten Kavität eingeführt, sondern an ein seitlich im Leadframe angeordnetes Anspritz-Fenster 24 angelegt oder in das Anspritz-Fenster 24 eingeführt. Somit befindet sich die Abrißstelle 25 nicht gegenüber dem Leadframe, sondern grenzt an das Spritzmasse-Volumen der massiv ausgebildeten Seitenwand des Gehäuses-Grundkörpers an. Dadurch ist es möglich, die Rückwand 8b des Gehäuse-Grundkörpers 100 mit geringer Dicke und daher ein Bauelement mit geringer Gesamthöhe herzustellen. Es kann eine Dicke der Rückwand von weniger als 0,3 mm, beispielsweise von 0,1 mm realisiert werden.

Aufgrund einer geringen Höhe der durch die Rückwand des Gehäuse-Grundkörpers gebildeten Rückseite eines solchen Bauelements ist der Platzbedarf des Bauelements in vertikaler Richtung deutlich geringer als bei Bauelementen nach dem Stand der Technik. Das derartige Bauelement ist insbesondere für flache Anzeigemodule oder als Hintergrundbeleuchtung, beispielsweise für eine Flüssigkristallanzeige, geeignet.

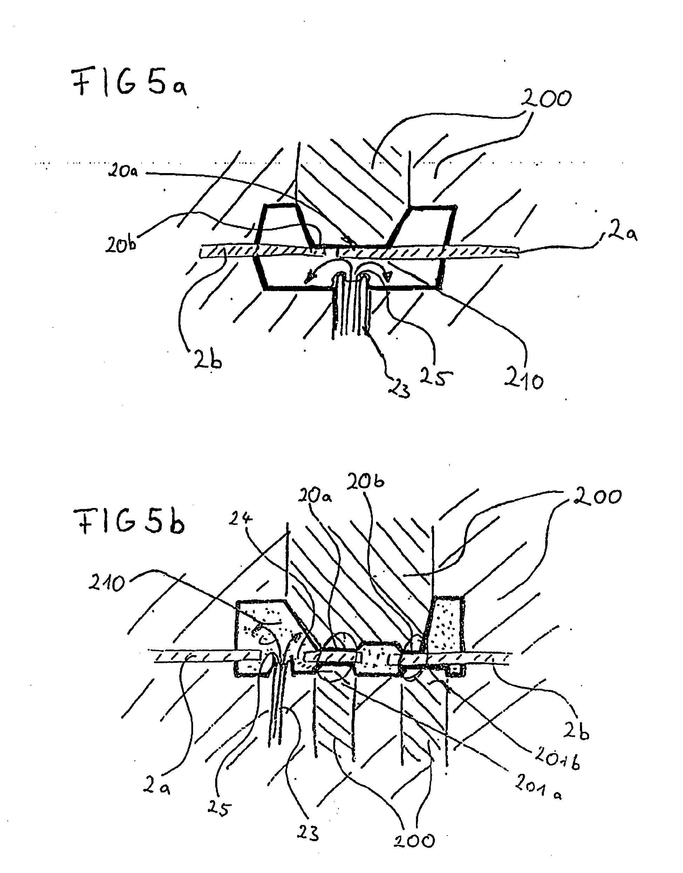

In den Figuren 5a und 5b ist jeweils eine Spritzgußform 200, gezeigt, die eine Kavität 210 aufweist. Beim Erzeugen eines Gehäuse-Grundkörpers ist es wichtig, dass elektrische Anschlußflächen 20a und 20b der Anschlußstreifen 2a und 2b, die für ein elektrisch leitendes Kontaktieren eines Chips mit den Anschlußstreifen 2a und 2b vorgesehen sind, nicht mit Spritzmasse bedeckt werden.

Bei der in Figur 5a dargestellten Spritzgußform 200 gemäß dem Stand der Technik wird die Spritzmasse mittels der Spritzdüse 23 von unten gegen die Anschlußstreifen 2a, 2b gespritzt, so daß die Anschlußstreifen 2a, 2b mit den elektrischen Anschlußflächen 20a und 20b gegen die Spritzgußform gedrückt werden (Verlauf der Spritzmasse beim Einspritzen ist durch Pfeile angedeutet). Dadurch werden die Anschlußflächen 20a, 20b während des Spritzpressens weitestgehend abgedichtet und die Gefahr einer Bedeckung der Anschlußflächen 20a, 20b mit Spritzmasse gemindert.

Demgegenüber wird bei einer Spritzgußform 200 für ein Bauelement-Gehäuse gemäß dem Verfahren der Erfindung, wie sie in Figur 5b gezeigt ist, die Spritzmasse über das Anspritz-Fenster 24 derart in die Kavität 210 gespritzt, dass ein Andrücken der Anschlußflächen 20a und 20b an die Spritzgußform, wie es im vorangehenden Absatz geschildet ist, nicht stattfindet. Es besteht vielmehr die Gefahr, dass die Anschlußstreifen 2a, 2b und damit die Anschlußflächen 20a, 20b von der Spritzgußform weggedrückt werden und sich ein Spalt zwischen der oberen Innenwand der Spritzgußform und den Anschlußflächen 20a, 20b bildet, der dann eine Bedeckung der Anschlußflächen 20a, 20b verursacht (Verlauf der Spritzmasse beim Einspritzen ist wiederum durch Pfeile angedeutet).

Damit die Anschlußflächen 20a, 20b bei der Vorgehensweise gemäß der Erfindung nicht von der oberen Innenwand der Spritzgußform 200 weggedrückt werden, ist eine Spritzgußform 200 (man vgl. Figur 5b) derart gestaltet, daß sie bei eingespannten Anschlußstreifen 2a, 2b im geschlossenen Zustand auch auf der den Anschlußflächen 20a, 20b gegenüberliegenden Flächen der Anschlußstreifen 2a, 2b mit einer Innenseite anliegt. Dadurch werden die Anschlußstreifen 2a, 2b in einem Bereich der Anschlußflächen 20a, 20b derart an die zugeordnete Innenwandung der Spritzform gedrückt, daß sie abgedichtet sind. Somit ist bei einer derartigen Spritzgußform 200 die Gefahr, daß während des Spritzpressens eines Gehäuse-Grundkörpers die Anschlußflächen 20a,20b mit Spritzmasse bedeckt werden, erheblich reduziert.

Ein mit einer derartigen Spritzgußform 200 hergestellter Gehäuse-Grundkörper weist in Bereichen der Anschlußstreifen 2a,2b, die den Anschlußflächen 20a, 20b gegenüberliegen, Aussparungen in der Rückwand des Gehäuse-Grundkörpers auf. Die in diesen Bereichen nach außen freiliegenden Flächen der Anschlußstreifen 2a,2b können nachfolgend nach außen elektrisch isoliert werden. Dies kann beispielsweise durch Beschichten mit einem elektrisch isolierenden Material, beispielsweise elektrisch isolierendem Lack geschehen.

Die Erläuterung der Erfindung anhand der gezeigten Ausführungsbeispiele ist selbstverständlich nicht als Beschränkung der Erfindung hierauf zu verstehen. Die Erfindung beschränkt sich nicht auf die Anzahl oder besondere Ausführungsformen der in Figuren schematisch dargestellten Ausführungsbeispiele. Vielmehr ist die Erfindung in den Patentansprüchen angegeben.

## Patentansprüche

1. Verfahren zur Herstellung eines Leadframe-basierten Gehäuses für ein oberflächenmontierbares elektronisches Bauelement mit einem eine Vorderseite und eine Rückseite aufweisenden Leadframe, das zumindest zwei elektrische Anschlußstreifen (2a, 2b) aufweist, und einem spritzgegossenen oder spritzgepreßten Gehäuse-Grundkörper (8a, 8b) aus einer elektrisch isolierenden Spritzmasse, der ein an der Vorderseite des Leadframes angeordnetes Vorderteil (8a) und eine an der Rückseite des Leadframes angeordnete Rückwand (8b) aufweist, wobei das Leadframe mindestens ein Anspritz-Fenster (24) aufweist, durch welches hindurch der Gehäuse-Grundkörper von einer Rückseite des Leadframes her an das Leadframe gespritzt ist,
mit folgenden Verfahrensschritten:
- Bereitstellen des Leadframes mit den beiden Anschlußstreifen (2a, 2b) und dem Anspritz-Fenster (24),
- Anlegen einer Spritzform (200) an das Leadframe, die um das Leadframe eine Kavität für die Ausbildung des Gehäuse-Grundkörpers (8a, 8b) bildet, und Einführen oder Anlegen einer Spritzdüse (23) in oder an das Anspritz-Fenster (24),
- Einspritzen der Spritzmasse in die Kavität,
- zumindest teilweises Aushärten der Spritzmasse, und
- Öffnen der Spritzform (200) einschließlich Entfernen der Spritzdüse (23),
**dadurch gekennzeichnet, dass**
die Spritzdüse (23) beim Anspritzen durch einen Teil der Kavität hindurch, der einen Rückwandteil des Gehäuse-Grundkörpers (8a, 8b) an der Rückseite des Leadframes erzeugt, zu dem Anspritz-Fenster (24) des Leadframes geführt wird.

2. Verfahren nach dem vorherigen Anspruch,
bei dem als Spritzmasse ein Thermoplastmaterial verwendet wird.

3. Verfahren nach einem der obigen Ansprüche,
bei dem das Anspritz-Fenster (24) in einem der elektrischen Anschlußstreifen (2a, 2b) angeordnet ist.

4. Verfahren nach einem der obigen Ansprüche,
bei dem die Rückwand mit einer Dicke von weniger als 0,3 mm und größer als 0 mm erzeugt wird.

5. Verfahren nach einem der obigen Ansprüche,
bei dem in dem Gehäuse-Grundkörper (8a, 8b) im Vorderteil (8a) eine Ausnehmung zur Aufnahme eines strahlungsemittierenden und/oder strahlungsdetektierenden Chips gebildet wird, wobei das Anspritz-Fenster (24) im Bereich einer die Ausnehmung begrenzenden Wand des Vorderteils (8a) angeordnet ist.

6. Verfahren nach dem vorhergehenden Anspruch,
bei dem die Ausnehmung als Reflektor gebildet wird.

## Claims

1. Method for producing a leadframe-based housing for a surface-mountable electronic component, with a leadframe having a front side and a back side and comprising at least two electrical connector strips (2a, 2b), and an injection-moulded or transfer-moulded main housing body (8a, 8b) made from an electrically insulating injection-moulding compound and comprising a front part (8a) arranged on the front side of the leadframe and a back wall (8b) arranged on the back side of the leadframe, wherein the leadframe comprises at least one injection aperture (24), through which the main housing body is injection-moulded onto the leadframe from a back side of the lead frame,
with the following method steps:
- providing the leadframe comprising the two connector strips (2a, 2b) and the injection aperture (24),
- applying to the leadframe an injection mould (200) that forms around the leadframe a cavity for forming the main housing body (8a, 8b), and inserting or placing an injection nozzle (23) into or onto the injection aperture (24),
- injecting the injection-moulding compound into the cavity,
- at least partially curing the injection-moulding compound, and
- opening the injection mould (200), including removing the injection nozzle (23),
**characterized in that**
during injection, the injection nozzle (23) is guided through a part of the cavity that creates a back wall part of the main housing body (8a, 8b) on the back side of the leadframe to the injection aperture (24) of the leadframe.

2. Method according to the preceding claim, in which a thermoplastic material is used as the injection-moulding compound.

3. Method according to one of the above claims, in which the injection aperture (24) is arranged in one of the electrical connector strips (2a, 2b).

4. Method according to one of the above claims, in which the back wall is created with a thickness of less than 0.3 mm and greater than 0 mm.

5. Method according to one of the above claims, in which, in the main housing body (8a, 8b), a recess for receiving a radiation-emitting and/or radiation-detecting chip is formed in the front part, the injection aperture (24) being arranged in the region of a wall of the front part (8a) that delimits the recess.

6. Method according to the preceding claim, in which the recess is formed as a reflector.

## Revendications

1. Procédé de fabrication d'un boîtier à base de grille de connexion pour un composant électronique pouvant être monté en surface comportant une grille de connexion présentant une face avant et une face arrière, qui présente au moins deux bandes de raccordement électrique (2a, 2b), et un bâti de boîtier (8a, 8b) moulé par injection ou par transfert et constitué d'une masse d'injection électriquement isolante qui présente une partie avant (8a) disposée sur la face avant de la grille de connexion et une paroi arrière (8b) disposée sur la face arrière de la grille de connexion, dans lequel la grille de connexion présente au moins une fenêtre d'injection (24) à travers laquelle le bâti de boîtier est injecté sur la grille de connexion à partir d'une face arrière de la grille de connexion,
comportant les étapes de procédé suivantes :
- fourniture de la grille de connexion comportant les deux bandes de raccordement (2a, 2b) et la fenêtre d'injection (24),
- application sur la grille de connexion d'un moule d'injection (200) qui forme une cavité autour de la grille de connexion pour la réalisation du bâti de boîtier (8a, 8b), et introduction ou application d'une buse d'injection (23) dans ou sur la fenêtre d'injection (24),
- injection de la masse d'injection dans la cavité,
- durcissement au moins partiel de la masse d'injection, et
- ouverture du moule d'injection (200) tout en retirant la buse d'injection (23),
**caractérisé en ce que**
la buse d'injection (23), lors de l'injection à travers une partie de la cavité créant une partie de paroi arrière du bâti de boîtier (8a, 8b) sur la face arrière de la grille de connexion, est guidée vers la fenêtre d'injection (24) de la grille de connexion.

2. Procédé selon la revendication précédente, dans lequel un matériau thermoplastique est utilisé en tant que masse d'injection.

3. Procédé selon l'une des revendications précédentes, dans lequel la fenêtre d'injection (24) est disposée dans l'une des bandes de raccordement électrique (2a, 2b).

4. Procédé selon l'une des revendications précédentes, dans lequel la paroi arrière est créée avec une épaisseur inférieure à 0,3 mm et supérieure à 0 mm.

5. Procédé selon l'une des revendications précédentes, dans lequel un évidemment est formé dans le bâti de boîtier (8a, 8b) dans la partie avant (8a) pour la réception d'une puce d'émission de rayonnement et/ou de détection de rayonnement, dans lequel la fenêtre d'injection (24) est disposée dans la région d'une paroi de la partie avant (8a) délimitant l'évidemment.

6. Procédé selon l'une des revendications précédentes, dans lequel l'évidemment est réalisé sous la forme d'un réflecteur.
